# EUROPEAN PATENT APPLICATION

(11) **EP 2 262 249 A1**
(43) Date of publication of application: **15.12.2010**
(21) Application number: 09172789.1
(22) Date of filing: 12.10.2009
(51) Int. Cl.: H04N 5/50, H03J 7/02

(54) **Blind scan apparatus and blind scan method for use in digital video broadcast system**

(30) Priority: 02.06.2009 TW 98118199
(71) Applicant: ITE Tech. Inc, Hsinchu (TW)
(72) Inventor: Wu, Chun-Yi, Taipei County 220 (TW); Wang, Chien-Fa, Taipei County (TW)
(74) Representative: Becker Kurig Straus

(57) **Abstract**

An exemplary embodiment of the present invention provides a blind scan method for use in a digital video broadcast system. A digital video broadcast system receiver using the blind scan method needs no tables to record the frequency bands or region codes corresponding to the countries and regions, and even needs no specific information input by the users to speed up the scan process. The blind scan method scans the currently-existing combinations of frequency bands, and optimizes the sequence of scanning frequency bands for different situations, thereby reducing the scanning time. Therefore, the blind scan method can ensure that the frequency band used to transmit the digital video broadcast signals can be scanned.

## Description

### FIELD OF THE INVENTION

The present invention relates to a digital video broadcast system receiver, and more particularly, to a blind scan apparatus for a digital video broadcast system receiver and a blind scan method.

### BACKGROUND OF THE INVENTION

Following development of communication and image processing technology, traditional analog video broadcast systems are being replaced by digital video broadcast systems. Currently, there are six frequency bands available for the digital video broadcast system to be used to transmit digital video broadcast signals. Three of the six frequency bands include 6 MHz frequency band, 7 MHz frequency band, and 8 MHz frequency band within the very high frequency (VHF) range, the other three frequency bands include 6 MHz frequency band, 7 MHz frequency band, and 8 MHz frequency band within the ultra high frequency (UHF) range. Each of the frequency bands has a particular band width. In addition, the VHF and UHF frequency bands are typically used in combination. Therefore, there may be the following nine frequency band combinations: 6V (6 MHz frequency band within the VHF range) and 6U (6 MHz frequency band within the UHF range), 6V and 7U (7 MHz frequency band within the UHF range), 6V and 8U (8 MHz frequency band within the UHF range), 7V (7 MHz frequency band within the VHF range) and 6U, 7V and 7U, 7V and 8U, 8V (8 MHz frequency band within the VHF range) and 6U, 8V and 7U, 8V and 8U.

However, in different countries or regions, program providers of the digital video broadcast system choose different frequency bands to transmit digital video broadcast signals. Therefore, to successfully receive digital video broadcast signals, the digital video broadcast receiver must know the frequency band combinations used to transmit the digital video broadcast signals. The aforementioned six frequency band combinations have a total of 182 frequencies. Therefore, in order to know the frequency used to transmit the digital video broadcast signals, the traditional digital video broadcast system receiver must scan all the 182 frequencies and thus may spend a lot of time on the frequency scan.

In order to reduce the scanning time of the digital video broadcast system receiver, U.S. Publication No. 2007/0067816 proposes a method which utilizes a table to obtain the frequency band used to transmit the digital video broadcast signals. This table records the relationship between the frequency bands and region codes representing the countries or regions. Once a user inputs the region code representing the country or region where the user is located, the digital video broadcast system receiver can quickly scan the frequency band used to transmit the digital video broadcast signals according to the relationship recorded in the table.

However, to mobile users, it would be very inconvenient if they must input the corresponding region code to allow the digital video broadcast system receiver to successfully receive the digital video broadcast signals each time they are travelling from one country to another. In addition, if users do not know the region code of the country or region where they are located, they must first obtain the correct region code before they input the corresponding region code to allow the digital video broadcast system receiver to successfully receive the digital video broadcast signals. This may further increase the user inconvenience. Besides, utilizing the table to obtain the frequency band used to transmit the digital video broadcast signals requires extra storage space, which may increase the size of a chip of the digital video broadcast system receiver. Furthermore, if a desired frequency band and a corresponding region code are not stored in the table, the digital video broadcast system receiver may fail to receive the digital video broadcast signals.

In addition, U.S. Publication. No. 2006/0068781 proposes a method which uses previous scanning results to obtain the frequency band used to transmit the digital video broadcast signals. The method proposed by this patent also adopts the concept of establishing tables. In this method of scanning the frequency bands, the frequency band identified during a previous scan and its corresponding region code are stored in a table. Later scan can be performed only to those frequency bands previously stored in the table, thereby reducing the scanning time. As a result, this frequency band scanning method still needs extra storage space to store the table.

### SUMMARY OF THE INVENTION

Exemplary embodiments of the present invention provide a blind scan method for use in a digital video broadcast system receiver. Combinations of frequency bands used to transmit a digital video broadcast signal of at least one program comprise at least first to fourth frequency band combinations, the first frequency band combination has a second VHF frequency band and a third UHF frequency band, the second frequency band combination has a third VHF frequency band and the third UHF frequency band, the third frequency band has the second VHF frequency band and a second UHF frequency band, and the fourth frequency band has a first VHF frequency band and a first UHF frequency band. The blind scan method comprises steps of: (1) receiving the digital video broadcast signal by using a receiving unit; (2) scanning the second VHF frequency band of the digital video broadcast signal by using a scanning unit; (3) determining whether or not there is any program on the second VHF frequency band of the digital video broadcast signal by using a determining unit; (4) scanning the third UHF frequency band of the digital video broadcast signal by using the scanning unit if there is any program on the second VHF frequency band of the digital video broadcast signal; (5) determining whether or not there is any program on the third UHF frequency band of the digital video broadcast signal by using the determining unit; and (6) ending the blind scan method if there is any program on the third UHF frequency band of the digital video broadcast signal.

Exemplary embodiments of the present invention provide a blind scan apparatus for use in a digital video broadcast system receiver. Combinations of frequency bands used to transmit a digital video broadcast signal of at least one program comprise at least first to fourth frequency band combinations. The first frequency band combination has a second VHF frequency band and a third UHF frequency band, the second frequency band combination has a third VHF frequency band and the third UHF frequency band, the third frequency band has the second VHF frequency band and a second UHF frequency band, and the fourth frequency band has a first VHF frequency band and a first UHF frequency band. The blind scan apparatus comprises a frequency band scanning unit adapted for performing a blind scan and comprising a receiving unit, a scanning unit and a determining unit. The receiving unit is adapted for receiving the digital video broadcast signal. The scanning unit is adapted for scanning the second VHF frequency band of the digital video broadcast signal. The determining unit is adapted for determining whether or not there is any program on the second VHF frequency band of the digital video broadcast signal. The scanning unit scans the third UHF frequency band of the digital video broadcast signal if there is any program on the second VHF frequency band of the digital video broadcast signal. The determining unit is adapted for determining whether or not there is any program on the third UHF frequency band of the digital video broadcast signal. The blind scan apparatus ends the blind scan if there is any program on the third UHF frequency band of the digital video broadcast signal.

In view of the foregoing, the blind scan method and blind scan apparatus scan the frequency band combinations that currently exist around the world and exclude the scanning of those non-existing frequency band combinations, thereby reducing the scanning time. In addition, the blind scan method and blind scan apparatus can optimize the sequence of scanning the frequency bands for different situations thus further reducing the scanning time.

In order to make the aforementioned and other features and advantages of the present invention more comprehensible, embodiments accompanied with figures are described in detail below.

### BRIEF DESCRIPTION OF THE DRAWINGS

Fig. 1 illustrates a list of frequency bands that are used by digital video broadcast systems in corresponding countries.

Fig. 2 illustrates a flow chart of a blind scan method according to an exemplary embodiment of the present invention.

Fig. 3 illustrates a flow chart of another blind scan method according to an exemplary embodiment of the present invention.

Fig. 4 illustrates a flow chart of still another blind scan method according to an exemplary embodiment of the present invention.

Fig. 5 illustrates a system block diagram of a blind scan apparatus according to an exemplary embodiment of the present invention.

### DESCRIPTION OF THE EMBODIMENTS

Exemplary embodiments of the present invention provide a blind scan apparatus and a blind scan method for identifying a transmission frequency band used to transmit digital video broadcast signals. The blind scan apparatus and blind scan method may be used in a personal computer TV, a set-top box (STB) and a portable TV that receive digital video broadcast signals. Because the users does not need to set or know which region or country they are located when the present blind scan apparatus and method are used, the present blind scan apparatus and method can greatly facilitate the use of a portable TV.

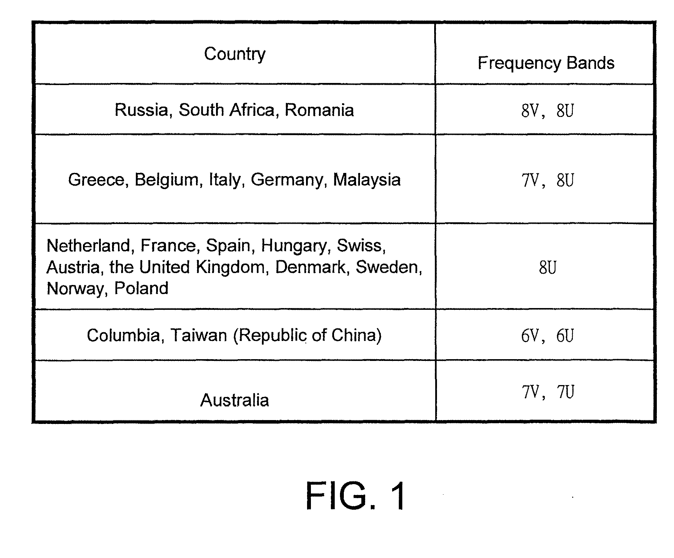

Reference is now made first to Fig. 1, which is a list of frequency bands that are used by digital video broadcast systems in corresponding countries. It is noted that 6V, 7V and 8V represent the 6 MHz frequency band, 7 MHz frequency band and 8 MHz frequency band within the VHF range, respectively, and 6U, 7U, 8U represent the 6 MHz frequency band, 7 MHz frequency band and 8 MHz frequency band within the UHF range, respectively. As shown in Fig. 1, currently, the frequency bands used by the digital video broadcast systems in the majority of countries can generally be categorized into four types of frequency band combinations. The first frequency band combination is the combination of 7V and 8U which is used by, for example, Germany and Italy. The second frequency band combination is the combination of 8V and 8U which is used by, for example, the U.K., France and a majority of EU countries. The third frequency band combination is the combination of 7V and 7U which is used by, for example, Australia. The fourth frequency band combination is the combination of 6V and 6U which is used by, for example, Taiwan (Republic of China) and Columbia.

Knowing that the frequency bands used by the digital video broadcast systems in the majority of countries can generally be categorized into four types of frequency band combinations according to Fig. 1, the blind scan method can correctly find out the frequency band used to transmit the digital video broadcast signals by scanning only the aforementioned four frequency band combinations. For example, there is no combination of 6V and 8U in the currently-existing frequency band combinations. Therefore, if a program has already been located on the 6V frequency band, there would be no need to search for programs on the 8U frequency band.

Besides, in order to further reduce the time for scanning the frequency bands, the sequence of scanning the frequency bands can be optimized for different situations. For example, considering that Germany has the largest amount of users of digital video broadcast systems, the combination of 7V and 8U can be taken into account for optimizing the sequence of scanning the frequency bands, i.e., it is first determined whether or not the frequency band used to transmit the digital video broadcast signals is 7V or 8U. For another example, if the digital video broadcast system receivers are designed to be mainly sold to customers in Taiwan (Republic of China), the combination of 6V and 6U can be taken into account for optimizing of the sequence of scanning the frequency bands, i.e., it is first determined whether or not the frequency band used to transmit the digital video broadcast signals is 6V or 6U.

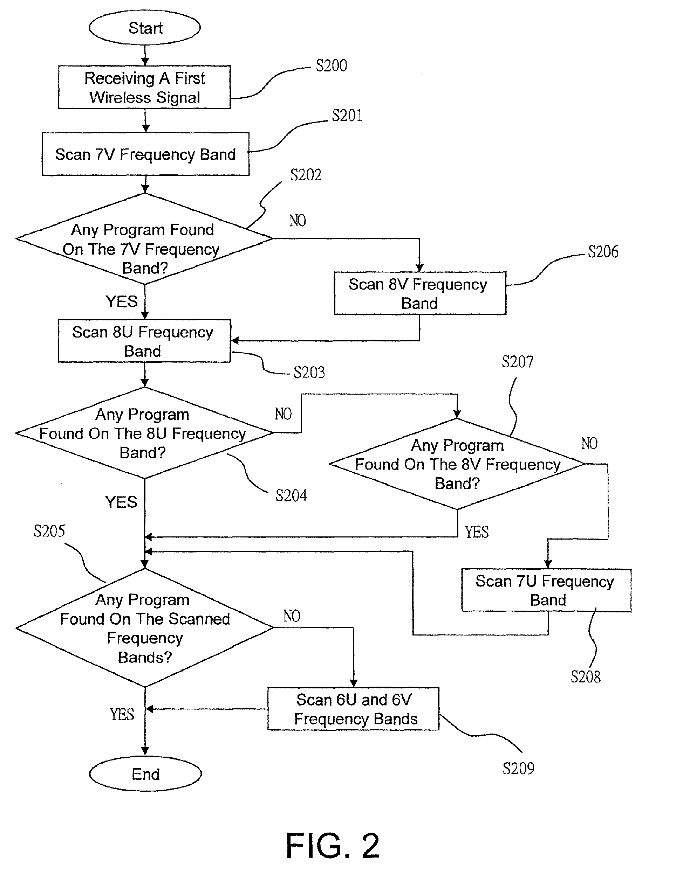

Reference is now made to Fig. 2, which is a flow chart of a blind scan method according to an exemplary embodiment of the present invention. It is noted that the blind scan method is designed to be used with the digital video broadcast system receivers in Germany and, therefore, the blind scan method can reduce more scanning time when used in Germany. However, the digital video broadcast system receiver using the blind scan method can still identify the frequency bands used to transmit the digital video broadcast signals when used in regions or countries other than Germany. In other words, the blind scan method is a universal blind scan method which eliminates the need of tables or input of specific information by a user.

Firstly, at step S200, a first wireless signal is received. At step S201, the 7V frequency band of the first wireless signal is scanned and a 7V frequency band scanning result is generated. At step S201, it is determined whether or not any program is found on the 7V frequency band according to the 7V frequency band scanning result. If there is any program found on the 7V frequency band, the method proceeds to step S203; otherwise, the method proceeds to step S206. If there is no program found on the 7V frequency band, the 8V frequency band of the first wireless signal is scanned and an 8V frequency band scanning result is generated at step S206. If there is any program found on the 7V frequency band, the 8U frequency band of the first wireless signal is scanned and an 8U frequency band scanning result is generated at step S203.

Then, at step S204, it is determined whether or not any program is found on the 8U frequency band. If there is any program found on the 8U frequency band, the method proceeds to step S205; otherwise, the proceeds to step S207. If there is no program found on the 8U frequency band, it is then determined whether or not any program is found on the 8V frequency band according to the 8V frequency band scanning result at step S207. If there is any program found on the 8V frequency band, the method proceeds to step S205; otherwise, the method proceeds to step S208. If there is no program found on the 8V frequency band, the 7U frequency band of the first wireless signal is scanned and a 7U frequency band scanning result is generated at step S208.

At step S205, it is determined whether or not any program is found on the scanned frequency bands. If there is any program found on the scanned frequency bands, the blind scan method ends; otherwise, the method proceeds to step S209. If there is no program found on the scanned frequency bands, the 6U and 6V frequency bands of the first wireless signal are scanned and 6U and 6V frequency bands scanning results are generated at step S209.

For example, if the digital video broadcast system receiver using the present blind scan method is used in countries or regions adopting the 7V and 8U frequency bands, only the steps S200 ~ S205 are performed. In other words, only the 7V and 8U frequency bands are scanned. As a result, the scanning time can be greatly reduced. For another example, if the digital video broadcast system receiver using the present blind scan method is used in countries or regions adopting the 8U or 8U and 8V frequency bands, only the steps S200 ~ S202, S206 and S203 ~ S205 are performed. In other words, only the 7V, 8V and 8U frequency bands are scanned.

For another example, if the digital video broadcast system receiver using the present blind scan method is used in countries or regions adopting the 8V frequency band, only the steps S200 ~ S202, S206, S204, S207 and S205 are performed. In other words, only the 7V, 8V and 8U frequency bands are scanned. For another example, if the digital video broadcast system receiver using the present blind scan method is used in countries or regions adopting the 6V and 6U frequency bands, only the steps S200 - S202, S206, S203, S204, S207, S208, S205 and S209 are performed. In other words, the 6V, 7V, 8V, 6U, 7U and 8U frequency bands are all scanned.

For still another example, if the digital video broadcast system receiver using the present blind scan method is used in countries or regions adopting the 7V and 7U frequency bands, only the steps S200 ~ S204, S207, S208 and S205 are performed. In other words, only the 7V, 8V and 7U frequency bands are scanned. It is noted that, because the 8V frequency band is not scanned, the blind scan method automatically considers that there is no program found on the 8V frequency band and directly proceeds to step S208.

In view of the foregoing, the blind scan method of Fig. 2 can ensure that the frequency band used to transmit the digital video broadcast signals can be scanned. In addition, when used in some particular regions or countries, the blind scan method can greatly reduce the scanning time. However, when the above-described blind scan method is used in Taiwan (Republic of China), a large amount of scanning time can be needed because all the 6V, 7V, 8V, 6U, 7U, and 8U frequency bands need to be scanned. Therefore, another blind scan method is described below which is more suitable for use in Taiwan.

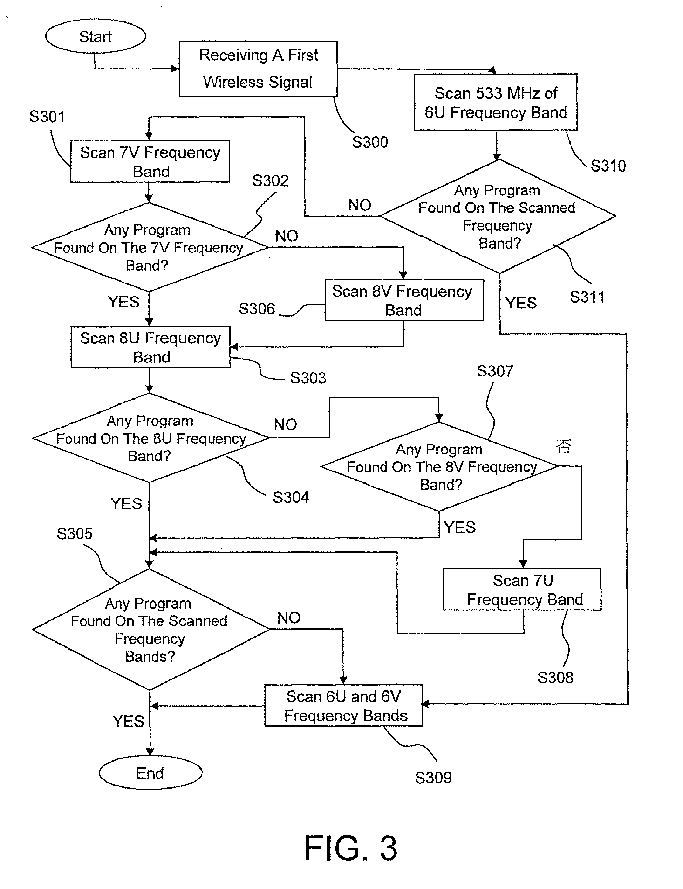

Reference is now made to Fig. 3, which is a flow chart of another blind scan method according to an exemplary embodiment of the present invention. Steps S300 ~ S309 of Fig. 3 are the same as steps S200 ~ S209 of Fig. 2 and therefore explanation thereof is not repeated herein. The difference between the blind scan methods of Fig. 3 and Fig. 2 is that the bind scan method of Fig. 3 first scans the frequency bands that are adopted by Taiwan (Republic of China) for reducing the scanning time. At step S310, the frequency 533 MHz of the 6U frequency band of the first wireless signal is scanned and the 533 MHz scanning result is sent to the digital video broadcast system receiver. It should be noted that, while the 533 MHz of the 6U frequency band is scanned at step S310 in the exemplary embodiment, the present blind scan method may also scan another frequency within the 6U or 6V frequency band at which a program is being broadcasted or is predicted to be broadcasted. Examples of such another frequency include 545 MHz and 581MHz. Then, at step S311, it is determined whether or not there is any program found at the frequency 533 MHz according to the 533 MHz scanning result. If there is any program at the frequency 533 MHz, the method directly proceeds to step S309; otherwise, the method proceeds to step 301.

Taking Taiwan (Republic of China) as an example, the digital video broadcast system receiver using the blind scan method of Fig. 3 performs steps S310, S311 and S309. In other words, only the 6U and 6V frequency bands are scanned thus reducing the scanning time. In addition, the blind scan method of Fig. 3 only pre-scans the frequency 533 MHz. Therefore, if not used in Taiwan, the digital video broadcast system receiver using the blind scan method of Fig. 3 only takes very little time for pre-scanning and thus the overall scanning time can still be reduced.

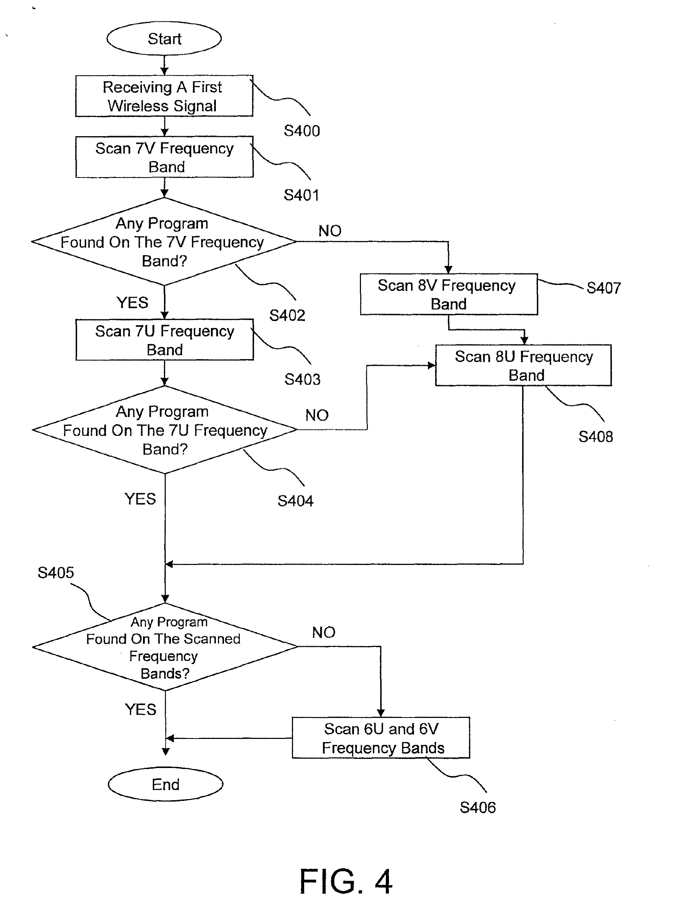

Reference is now made to Fig. 4, which is a flow chart of another blind scan method according to an exemplary embodiment of the present invention. It should be noted that the blind scan method of Fig. 4 is designed to be used with the digital video broadcast system receivers in Australia and, therefore, the blind scan method can reduce more scanning time when used in Australia. However, the digital video broadcast system receiver using the blind scan method can still identify the frequency band used to transmit the digital video broadcast signals when used in regions or countries other than Australia. In other words, the blind scan method is a universal blind scan method which eliminates the need of tables or input of specific information by a user.

Firstly, at step S400, a first wireless signal is received. At step S401, the 7V frequency band of the first wireless signal is scanned and the 7V frequency scanning result is sent to the digital video broadcast system receiver. At step S402, it is then determined whether or not any program is found on the 7V frequency band. If there is any program found on the 7V frequency band, the method proceeds to step S403; otherwise, the method proceeds to step S407. If there is any program found on the 7V frequency band, the 7U frequency band of the first wireless signal is scanned and a 7U frequency band scanning result is sent to the digital video broadcast system receiver at step S403. At step S404, it is determined whether or not any program is found on the 7U frequency band according to the 7U frequency band scanning result. If there is any program found on the 7U frequency band scanning result, the method proceeds to step S405; otherwise, the method proceeds to step S408.

If there is no program found on the 7V frequency band, the 8V frequency band of the first wireless signal is scanned and an 8V frequency band scanning result is sent to the digital video broadcast system receiver at step S407. At step S408, the 8U frequency band of the first wireless signal is scanned and an 8U frequency band scanning result is sent to the digital video broadcast system receiver. At step S405, it is determined whether or not any program is found on the scanned frequency bands according to the foregoing scanning results. If there is any program found on the scanned frequency bands, then the whole blind scan method ends; otherwise, the method proceeds to step S406. If there is no program found on the scanned frequency bands, the 6U and 6V frequency bands of the first wireless signal are scanned, and 6U and 6V frequency bands scanning results are generated at step S406.

For example, if the digital video broadcast system receiver using the present blind scan method is used in countries or regions adopting the 7V and 7U frequency bands, only the steps S400 ~ S405 are performed. In other words, only the 7V and 7U frequency bands are scanned. As a result, the scanning time can be greatly reduced. For another example, if the digital video broadcast system receiver using the present blind scan method is used in countries or regions adopting the 8U or 8V frequency bands, only the steps S400 ~ S402, S405, S407 and S408 are performed. In other words, only the 7V, 8V and 8U frequency bands are scanned.

For another example, if the digital video broadcast system receiver using the present blind scan method is used in countries or regions adopting the 6V and 6U frequency band, only the steps S400 ~ S402, S407, S408, S405 and S406 are performed. In other words, the 6V, 7V, 8V, 6U and 8U frequency bands are all scanned. For another example, if the digital video broadcast system receiver using the present blind scan method is used in countries or regions adopting the 7V and 8U frequency bands, only the steps S400 ~ S404, S408 and S405 are performed. In other words, only the 7V, 7U and 8U frequency bands are all scanned.

In view of the foregoing, the blind scan method of Fig. 4 can ensure that the frequency band used to transmit the digital video broadcast signals can be scanned. In addition, when used in some particular regions or countries, the blind scan method can greatly reduce the scanning time. It is noted that the sequence of scanning the frequency bands can be optimized based on the expectation on user population of each frequency band or based on market situations or other objective and subjective factors. In brief, the blind scan method illustrated in the exemplary embodiments of the present invention scans only the currently existing combinations of frequency bands and does not scan those un-existing combinations of frequency bands, thereby reducing the scanning time.

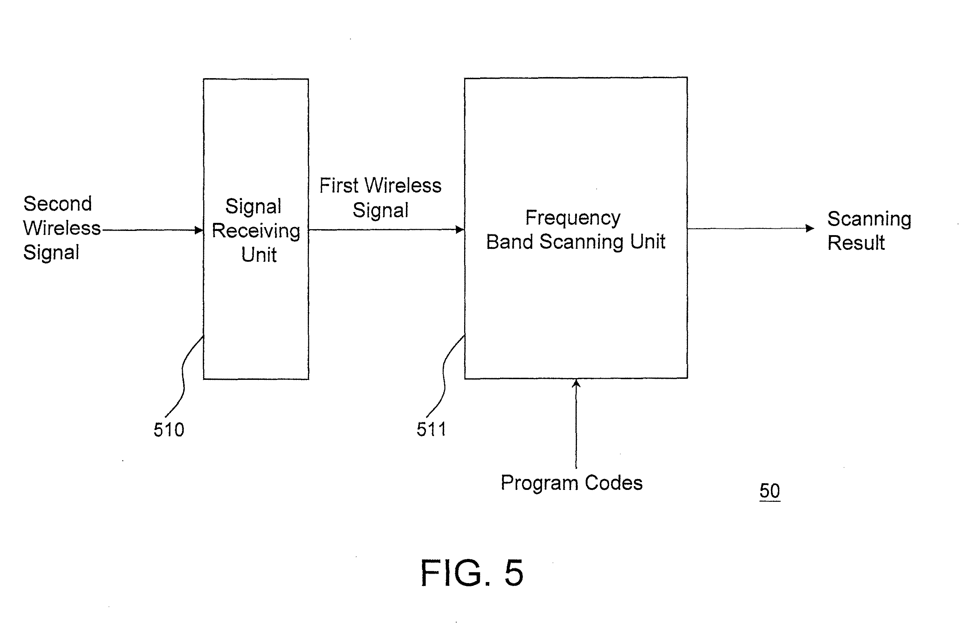

Reference is now made to Fig. 5, which is a system block diagram of a blind scan apparatus 50 according to an exemplary embodiment of the present invention. This blind scan apparatus 50 is used to scan the frequency band used to transmit the digital video broadcast signals and inform the digital video broadcast system receiver of the scanned frequency band such that the digital video broadcast system receiver can successfully receive the digital video broadcast signals from the scanned frequency band. The digital video broadcast system receiver then can demodulate and decode the received digital video broadcast signals such that images formed from the received digital video broadcast signals can be displayed on a display.

The blind scan apparatus 50 includes a signal receiving unit 510 and a frequency band scanning unit 511. The signal receiving unit 510 is coupled to the frequency band scanning unit 511. The signal receiving unit 510 is used to receive a second wireless signal through a wireless channel and, therefore, the signal receiving unit 510 may be a set of antennae and output a first wireless signal to the frequency band scanning unit 511. If it is assumed that the signal receiving unit 510 is a set of the unity-gain antennae, then the second wireless signal is the same as the first wireless signal. However, some non-ideal factors such as attenuation or noises typically exist in the wireless channels which affect the first wireless signal that is received. Therefore, the signal receiving unit 510 may further include elements such as a signal amplifier, an equalizer or a filter. In brief, implementation of the signal receiving unit 510 is in no way limited to the particular embodiments described herein.

The frequency band scanning unit 511 includes a receiving unit, a scanning unit and a determining unit. The receiving unit is used to receive the first wireless signal. The scanning unit is used to scan multiple frequency bands of the first wireless signal and generate scanning results corresponding to the frequency bands. The determining unit is used to determine whether or not there is any program broadcasted on at least one of the frequency bands so as to further determine whether or not to allow the scanning unit to scan a next frequency band or end the whole blind scan method. After the blind scan method ends, the digital video broadcast system receiver receives the scanning results and receives digital video broadcast signals on the frequency band used to transmit the digital video broadcast signals according to the scanning results.

In scanning various frequency bands and determining whether or not there is any program broadcasted on the scanned frequency band, the scanning unit and determining unit of the frequency band scanning unit 511 can perform the blind scan methods as described above. That is, the frequency band scanning unit 511 optimizes the scanning of multiple combinations of frequency bands to reduce the scanning time. While a number of blind scan methods has been described above, if there comes a new frequency combination, or optimization is needed for a different situation, the operation and sequence performed by the receiving unit, the scanning unit and determining unit of the frequency band scanning unit 511 can be updated by updating program codes, such that the blind scan method used by the frequency band scanning unit 511 can be flexibly used. Therefore, the frequency band scanning unit 511 may be a circuit with memory and processor, a field programmable gate array (FPGA), or other circuit components in which scanning and determining sequence can be updated by updating program codes.

In summary, the exemplary embodiments of the present invention provide a number of blind scan methods and apparatus. These scan methods are all designed to scan the frequency band combinations that currently exist around the world and exclude the scanning of those non-existing frequency band combinations, thereby reducing the scanning time. In addition, the blind scan method can optimize the sequence of scanning the frequency bands for different situations thus further reducing the scanning time. Besides, the blind scan method can ensure that the frequency band used to transmit the digital video broadcast signals can be scanned.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A blind scan method for use in a digital video broadcast system receiver, wherein combinations of frequency bands used to transmit a digital video broadcast signal of at least one program comprise at least first to fourth frequency band combinations, the first frequency band combination has a second VHF frequency band and a third UHF frequency band, the second frequency band combination has a third VHF frequency band and the third UHF frequency band, the third frequency band has the second VHF frequency band and a second UHF frequency band, the fourth frequency band has a first VHF frequency band and a first UHF frequency band, the blind scan method comprising:
receiving the digital video broadcast signal by using a receiving unit;
scanning the second VHF frequency band of the digital video broadcast signal by using a scanning unit;
determining whether or not there is any program on the second VHF frequency band of the digital video broadcast signal by using a determining unit;
scanning the third UHF frequency band of the digital video broadcast signal by using the scanning unit if there is any program on the second VHF frequency band of the digital video broadcast signal;
determining whether or not there is any program on the third UHF frequency band of the digital video broadcast signal by using the determining unit; and
ending the blind scan method if there is any program on the third UHF frequency band of the digital video broadcast signal.

2. The blind scan method according to claim 1, further comprising:
scanning the third VHF frequency band and the third UHF frequency band of the digital video broadcast signal by using the scanning unit if there is no program on the second VHF frequency band of the digital video broadcast signal;
determining whether or not there is any program on the third VHF frequency band of the digital video broadcast signal by using the determining unit if there is no program on the third UHF frequency band of the digital video broadcast signal; and
ending the blind scan method if there is any program on the third VHF frequency band of the digital video broadcast signal.

3. The blind scan method according to claim 2, further comprising:
scanning the second UHF frequency band of the digital video broadcast signal by using the scanning unit if there is no program on the third VHF frequency band of the digital video broadcast signal;
determining whether or not there is any program on the second UHF frequency band of the digital video broadcast signal by using the determining unit; and
ending the blind scan method if there is any program on the second UHF frequency band of the digital video broadcast signal.

4. The blind scan method according to claim 3, further comprising scanning the first VHF frequency band and first UHF frequency band of the digital video broadcast signal by using the scanning unit and ending the blind scan method if there is no program on the second UHF frequency band of the digital video broadcast signal.

5. The blind scan method according to claim 4, wherein the first to third VHF frequency bands are 6 MHz frequency bands, 7 MHz frequency bands, and 8 MHz frequency bands within the very high frequency range, and the first to third UHF frequency bands are 6 MHz frequency bands, 7 MHz frequency bands, and 8 MHz frequency bands within the ultra high frequency range.

6. The blind scan method according to claim 5, wherein, prior to scanning the second VHF frequency band of the digital video broadcast signal by using the scanning unit, the blind scan method further comprises:
scanning a frequency of the first UHF or first VHF frequency band of the digital video broadcast signal by using the scanning unit, wherein the frequency of the first UHF frequency band of the digital video broadcast signal is 533 MHz, or a frequency within the first UHF frequency band at which a program is being broadcasted or is predicted to be broadcasted.;
determining whether or not there is any program at the frequency of the first UHF frequency band of the digital video broadcast signal by using the determining unit;
scanning the first VHF frequency band and first UHF frequency band of the digital video broadcast signal by using the scanning unit and ending the blind scan method if there is any program at the frequency of the first UHF frequency band of the digital video broadcast signal; and
scanning the second VHF frequency band of the digital video broadcast signal by using the scanning unit if there is no program at the frequency of the first UHF frequency band of the digital video broadcast signal.

7. The blind scan method according to claim 1, further comprising scanning the third VHF frequency band and third UHF frequency band of the digital video broadcast signal by using the scanning unit if there is no program on the second VHF frequency band of the digital video broadcast signal, and the method further comprises:
scanning the second UHF frequency band of the digital video broadcast signal by using the scanning unit if there is no program on the third UHF frequency band of the digital video broadcast signal;
determining whether or not there is any program on the third VHF frequency band or the second UHF frequency band of the digital video broadcast signal by using the determining unit; and
ending the blind scan method if there is any program on the third VHF frequency band or the second UHF frequency band of the digital video broadcast signal.

8. The blind scan method according to claim 7, further comprising scanning the first VHF frequency band and first UHF frequency band of the digital video broadcast signal by using the scanning unit and ending the blind scan method if there is no program on the third VHF frequency band and the second UHF frequency band of the digital video broadcast signal.

9. The blind scan method according to claim 8, wherein the first to third VHF frequency bands are 6 MHz frequency bands, 7 MHz frequency bands, and 8 MHz frequency bands within the very high frequency range, and the first to third UHF frequency bands are 6 MHz frequency bands, 8 MHz frequency bands, and 7 MHz frequency bands within the ultra high frequency range.

10. The blind scan method according to claim 8, wherein, prior to scanning the second VHF frequency band of the digital video broadcast signal by using the scanning unit, the blind scan method further comprises:
scanning a frequency of the first UHF frequency band of the digital video broadcast signal by using the scanning unit, wherein the frequency of the first UHF frequency band of the digital video broadcast signal is 533 MHz, or a frequency within the first VHF or first UHF frequency band at which a program is being broadcasted or is predicted to be broadcasted.;
determining whether or not there is any program at the frequency of the first UHF frequency band of the digital video broadcast signal by using the determining unit;
scanning the first VHF frequency band and first UHF frequency band of the digital video broadcast signal by using the scanning unit and ending the blind scan method if there is any program at the frequency of the first VHF frequency band of the digital video broadcast signal; and
scanning the second VHF frequency band of the digital video broadcast signal by using the scanning unit if there is no program at the frequency of the first UHF frequency band of the digital video broadcast signal.

11. A blind scan apparatus for use in a digital video broadcast system receiver, wherein combinations of frequency bands used to transmit a digital video broadcast signal of at least one program comprise at least first to fourth frequency band combinations, the first frequency band combination has a second VHF frequency band and a third UHF frequency band, the second frequency band combination has a third VHF frequency band and the third UHF frequency band, the third frequency band has the second VHF frequency band and a second UHF frequency band, the fourth frequency band has a first VHF frequency band and a first UHF frequency band, the blind scan apparatus comprising:
a frequency band scanning unit adapted for performing a blind scan and comprising a receiving unit, a scanning unit and a determining unit;
wherein, the receiving unit is adapted for receiving the digital video broadcast signal, the scanning unit is adapted for scanning the second VHF frequency band of the digital video broadcast signal;
the determining unit is adapted for determining whether or not there is any program on the second VHF frequency band of the digital video broadcast signal, the scanning unit scans the third UHF frequency band of the digital video broadcast signal if there is any program on the second VHF frequency band of the digital video broadcast signal;
the determining unit is adapted for determining whether or not there is any program on the third UHF frequency band of the digital video broadcast signal, the blind scan apparatus ends the blind scan if there is any program on the third UHF frequency band of the digital video broadcast signal.

12. The blind scan apparatus according to claim 11, wherein the scanning unit scans the third VHF frequency band and third UHF frequency band of the digital video broadcast signal if there is no program on the second VHF frequency band of the digital video broadcast signal, the determining unit determines whether or not there is any program on the third VHF frequency band of the digital video broadcast signal if there is no program on the third UHF frequency band of the digital video broadcast signal; and
the blind scan apparatus ends the blind scan if there is any program on the third VHF frequency band of the digital video broadcast signal.

13. The blind scan apparatus according to claim 12, wherein the scanning unit scans the second UHF frequency band of the digital video broadcast signal if there is no program on the third VHF frequency band of the digital video broadcast signal;
the determining unit determines whether or not there is any program on the second UHF frequency band of the digital video broadcast signal, the blind scan apparatus ends the blind scan if there is any program on the second UHF frequency band of the digital video broadcast signal.

14. The blind scan apparatus according to claim 13, wherein the scanning unit scans the first VHF frequency band and first UHF frequency band of the digital video broadcast signal and the blind scan apparatus ends the blind scan if there is no program on the second UHF frequency band of the digital video broadcast signal.

15. The blind scan apparatus according to claim 14, wherein the first to third VHF frequency bands are 6 MHz frequency bands, 7 MHz frequency bands, and 8 MHz frequency bands within the very high frequency range, and the first to third UHF frequency bands are 6 MHz frequency bands, 7 MHz frequency bands, and 8 MHz frequency bands within the ultra high frequency range.

16. The blind scan apparatus according to claim 15, wherein, prior to scanning the second VHF frequency band of the digital video broadcast signal by using the scanning unit, the scanning unit scans a frequency of the first UHF frequency band of the digital video broadcast signal, the determining unit determines whether or not there is any program at the frequency of the first UHF frequency band of the digital video broadcast signal, the scanning unit scans the first VHF frequency band and first UHF frequency band of the digital video broadcast signal and the blind scan apparatus ends the blind scan if there is any program at the frequency of the first UHF frequency band of the digital video broadcast signal, the scanning unit scans the second VHF frequency band of the digital video broadcast signal if there is no program at the frequency of the first UHF frequency band of the digital video broadcast signal. wherein the frequency of the first UHF frequency band of the digital video broadcast signal is 533 MHz, or a frequency within the first UHF or VHF frequency band at which a program is being broadcasted or is predicted to be broadcasted.

## Amended claims

### Amended claims in accordance with Rule 137(2) EPC.

**1.** A blind scan method for use in a digital video broadcast system receiver, wherein combinations of frequency bands used to transmit a digital video broadcast signal of at least one program comprise at least first to fourth frequency band combinations, the first frequency band combination has a second frequency band (7V) within the VHF range and a third frequency band (8U) within the UHF range, the second frequency band combination has a third frequency band (8V) within the VHF range and the third frequency band (8U) within the UHF range, the third frequency band combination has the second frequency band (7V) within the VHF range and a second frequency band (7U) within the UHF range, the fourth frequency band combination has a first frequency band (6V) within the VHF range and a first frequency band (6U) within the UHF range, wherein the first to third frequency bands within the VHF range are 6 MHz frequency bands, 7 MHz frequency bands, and 8 MHz frequency bands within the very high frequency, VHF, range, and the first to third frequency bands within the UHF range are 6 MHz frequency bands, 7 MHz frequency bands, and 8 MHz frequency bands within the ultra high frequency, UHF, range, the blind scan method comprising:
receiving (S200, S300) the digital video broadcast signal by using a receiving unit;
scanning (S201, S310) the second frequency band (7V) within the VHF range of the digital video broadcast signal by using a scanning unit;
determining (S202, S302) whether or not there is any program on the second frequency band (7V) within the VHF range of the digital video broadcast signal by using a determining unit;
scanning (S203, S303) the third frequency band (8U) within the UHF range of the digital video broadcast signal by using the scanning unit if there is any program on the second (7V) frequency band within the VHF range of the digital video broadcast signal;
determining (S204, S304) whether or not there is any program on the third frequency band (8U) within the UHF range of the digital video broadcast signal by using the determining unit; and
ending the blind scan method if there is any program on the third frequency band (8U) within the UHF range of the digital video broadcast signal.

**2.** The blind scan method according to claim 1, further comprising:
scanning (S206, S203, S306, S303) the third frequency band (8V) within the VHF range and the third frequency band (8U) within the UHF range of the digital video broadcast signal by using the scanning unit if there is no program on the second frequency band (7V) within the VHF range of the digital video broadcast signal;
determining (S207, S307) whether or not there is any program on the third frequency band (8V) within the VHF range of the digital video broadcast signal by using the determining unit if there is no program on the third frequency band (8U) within the UHF range of the digital video broadcast signal; and
ending the blind scan method if there is any program on the third frequency band (8V) within the VHF range of the digital video broadcast signal.

**3.** The blind scan method according to claim 2, further comprising:
scanning (S208, S308) the second frequency band (7U) within the UHF range of the digital video broadcast signal by using the scanning unit if there is no program on the third frequency band (8V) within the VHF range of the digital video broadcast signal;
determining (S205, S305) whether or not there is any program on the second frequency band (7U) within the UHF range of the digital video broadcast signal by using the determining unit; and
ending the blind scan method if there is any program on the second frequency band (7U) within the UHF range of the digital video broadcast signal.

**4.** The blind scan method according to claim 3, further comprising scanning (S209, S309) the first frequency band (6V) within the VHF range and first frequency band (6U) within the UHF range of the digital video broadcast signal by using the scanning unit and ending the blind scan method if there is no program on the second frequency band (7U) within the UHF range of the digital video broadcast signal.

**5.** The blind scan method according to claim 4, wherein, prior to scanning (S301) the second frequency band (7V) within the VHF range of the digital video broadcast signal by using the scanning unit, the blind scan method further comprises:
scanning (S310) a frequency of the first frequency range (6U) within the UHF range or first frequency band (6V) within the VHF range of the digital video broadcast signal by using the scanning unit, wherein the frequency of the first frequency band (6U) within the UHF range of the digital video broadcast signal is 533 MHz, or a frequency within the first frequency band (6U) within the UHF range at which a program is being broadcasted or is predicted to be broadcasted.;
determining (S311) whether or not there is any program at the frequency of the first frequency band (6U) within the UHF range of the digital video broadcast signal by using the determining unit;
scanning (S309) the first frequency band (6V) within the VHF range and first frequency band (6U) within the UHF range of the digital video broadcast signal by using the scanning unit and ending the blind scan method if there is any program at the frequency of the first frequency band (6U) within the UHF range of the digital video broadcast signal; and
scanning (S301) the second frequency band (7V) within the VHF range of the digital video broadcast signal by using the scanning unit if there is no program at the frequency of the first frequency band (6U) within the UHF range of the digital video broadcast signal.

**6.** A blind scan method for use in a digital video broadcast system receiver, wherein combinations of frequency bands used to transmit a digital video broadcast signal of at least one program comprise at least first to fourth frequency band combinations, the first frequency band combination has a second frequency band (7V) within the VHF range and a third frequency band (8U) within the UHF range, the second frequency band combination has a third frequency band (8V) within the VHF range and the third frequency band (8U) within the UHF range, the third frequency band combination has the second frequency band (7V) within the VHF range and a second frequency band (7U) within the UHF range, the fourth frequency band combination has a first frequency band (6V) within the VHF range and a first frequency band (6U) within the UHF range, wherein the first to third frequency bands within the VHF range are 6 MHz frequency bands, 7 MHz frequency bands, and 8 MHz frequency bands within the very high frequency range, and the first to third frequency bands within the UHF range are 6 MHz frequency bands, 7 MHz frequency bands, and 8 MHz frequency bands within the ultra high frequency range, the blind scan method comprising:
receiving (S400) the digital video broadcast signal by using a receiving unit;
scanning (S401) the second frequency band (7V) within the VHF range of the digital video broadcast signal by using a scanning unit;
determining (S402) whether or not there is any program on the second frequency band (7V) within the VHF range of the digital video broadcast signal by using a determining unit;
scanning (S407, S408) the third frequency band (8V) within the VHF range and third frequency band (8U) within the UHF range of the digital video broadcast signal by using the scanning unit if there is no program on the second frequency band (7V) within the VHF range of the digital video broadcast signal, scanning (S403) the second frequency band (7U) within the UHF range of the digital video broadcast signal by using the scanning unit if there is any program on the second frequency band (7V) within the VHF range of the digital video broadcast signal;
determining (S404) whether or not there is any program on the second frequency band (7U) within the UHF range of the digital video broadcast signal by using the determining unit; and
ending the blind scan method if there is any program on third frequency band (8U) within the UHF range, the third frequency band (8V) within the VHF range or the second frequency band (7U) within the UHF range of the digital video broadcast signal.

**7.** The blind scan method according to claim 6, further comprising scanning (S406) the first frequency band (6V) within the VHF range and first frequency band (6U) within the UHF range of the digital video broadcast signal by using the scanning unit and ending the blind scan method if there is no program on the third frequency band (8V) within the VHF range and the second frequency band (7U) within the UHF range of the digital video broadcast signal.

**8.** The blind scan method according to claim 7, wherein, prior to scanning the second frequency band (7V) within the VHF range of the digital video broadcast signal by using the scanning unit, the blind scan method further comprises:
scanning (S406) a frequency of the first frequency band (6U) within the UHF range of the digital video broadcast signal by using the scanning unit, wherein the frequency of the first frequency band (6U) within the UHF range of the digital video broadcast signal is 533 MHz, or a frequency within the first VHF frequency band (6V) or first frequency band (6U) within the UHF range at which a program is being broadcasted or is predicted to be broadcasted;
determining whether or not there is any program at the frequency of the first UHF (6U) frequency band of the digital video broadcast signal by using the determining unit;
scanning the first frequency band (6V) within the VHF range and first frequency band (6U) within the UHF range of the digital video broadcast signal by using the scanning unit and ending the blind scan method if there is any program at the frequency of the first frequency band (6V) within the VHF range of the digital video broadcast signal; and
scanning the second frequency band (7V) within the VHF range of the digital video broadcast signal by using the scanning unit if there is no program at the frequency of the first frequency band (6U) within the UHF range of the digital video broadcast signal.

**9.** A blind scan apparatus for use in a digital video broadcast system receiver, wherein combinations of frequency bands used to transmit a digital video broadcast signal of at least one program comprise at least first to fourth frequency band combinations, the first frequency band combination has a second frequency band (7V) within the VHF range and a third frequency band (8U) within the UHF range, the second frequency band combination has a third frequency band (8V) within the VHF range and the third frequency band (8U) within the UHF range, the third frequency band combination has the second frequency band (7V) within the VHF range and a second frequency band (7U) within the UHF range, the fourth frequency band combination has a first frequency band (6V) within the VHF range and a first frequency band (6U) within the UHF range, wherein the first to third frequency bands within the VHF range are 6 MHz frequency bands, 7 MHz frequency bands, and 8 MHz frequency bands within the very high frequency range, and the first to third frequency bands within the UHF range are 6 MHz frequency bands, 7 MHz frequency bands, and 8 MHz frequency bands within the ultra high frequency range, the blind scan apparatus comprising:
a frequency band scanning unit (511) adapted for performing a blind scan and comprising a receiving unit, a scanning unit and a determining unit;
wherein, the receiving unit is adapted for receiving (S200, S300) the digital video broadcast signal, the scanning unit is adapted for scanning (S201, S301) the second VHF (7V) frequency band of the digital video broadcast signal;
the determining unit is adapted for determining (S202, S302) whether or not there is any program on the second frequency band (7V) within the VHF range of the digital video broadcast signal, the scanning unit scans the third frequency band (8U) within the UHF range of the digital video broadcast signal if there is any program on the second frequency band (7V) within the VHF range of the digital video broadcast signal;
the determining unit is adapted for determining (S204, S304) whether or not there is any program on the third frequency band (8U) within the UHF range of the digital video broadcast signal, the blind scan apparatus ends the blind scan if there is any program on the third frequency band (8U) within the UHF range of the digital video broadcast signal.

**10.** The blind scan apparatus according to claim 9, wherein the scanning unit scans (S206, S203, S306, S303) the third frequency band (8V) within the VHF range and third frequency band (8U) within the UHF range of the digital video broadcast signal if there is no program on the second VHF (7V) frequency band of the digital video broadcast signal, the determining unit determines (S207, S307) whether or not there is any program on the third frequency band (8V) within the VHF range of the digital video broadcast signal if there is no program on the third frequency band (8U) within the UHF range of the digital video broadcast signal; and
the blind scan apparatus ends the blind scan if there is any program on the third frequency band (8V) within the VHF range of the digital video broadcast signal.

**11.** The blind scan apparatus according to claim 10, wherein the scanning unit scans the second frequency band (7U) within the UHF range of the digital video broadcast signal if there is no program on the third frequency band (8V) within the VHF range of the digital video broadcast signal;
the determining unit determines (S205, S305) whether or not there is any program on the second frequency band (7U) within the UHF range of the digital video broadcast signal, the blind scan apparatus ends the blind scan if there is any program on the second frequency band (7U) within the UHF range of the digital video broadcast signal.

**12.** The blind scan apparatus according to claim 11, wherein the scanning unit scans (S209, S309) the first frequency band (6V) within the VHF range and first frequency band (6U) within the UHF range of the digital video broadcast signal and the blind scan apparatus ends the blind scan if there is no program on the second frequency band (7U) within the UHF range of the digital video broadcast signal.

**13.** The blind scan apparatus according to claim 12, wherein, prior to scanning (S301) the second frequency band (7V) within the VHF range of the digital video broadcast signal by using the scanning unit, the scanning unit scans (S310) a frequency of the UHF frequency band (6U) within the UHF range of the digital video broadcast signal, the determining unit determines (S311) whether or not there is any program at the frequency of the first frequency band (6U) within the UHF range of the digital video broadcast signal, the scanning unit scans (S309) the first frequency band (6V) within the VHF range and first frequency band (6U) within the UHF range of the digital video broadcast signal and the blind scan apparatus ends the blind scan if there is any program at the frequency of the first frequency band (6U) within the UHF range of the digital video broadcast signal, the scanning unit scans (S301) the second frequency band (7V) within the VHF range of the digital video broadcast signal if there is no program at the frequency of the first frequency band (6U) within the UHF range of the digital video broadcast signal, wherein the frequency of the first frequency band (6U) within the UHF range of the digital video broadcast signal is 533 MHz, or a frequency within the first frequency band (6U) within the UHF range or first frequency band (6V) within the VHF range at which a program is being broadcasted or is predicted to be broadcasted.
